Europäisches Patentamt

European Patent Office

Office européen des brevets

(19)

(11) Publication number: **0 305 949**

**A1**

# EUROPEAN PATENT APPLICATION

(12)

(21) Application number: 88114052.9

(22) Date of filing: 29.08.88

(51) Int. Cl.⁴: **C04B 35/00** , **H01L 39/24** , **C04B 35/60**

(30) Priority: 28.08.87 JP 212967/87
28.08.87 JP 212968/87
28.08.87 JP 212969/87
28.08.87 JP 212970/87

(43) Date of publication of application:
08.03.89 Bulletin 89/10

(84) Designated Contracting States:
DE FR GB NL SE

(71) Applicant: MITSUBISHI KINZOKU KABUSHIKI KAISHA
5-2, Otemachi 1-chome
Chiyoda-ku Tokyo 100(JP)

(72) Inventor: Takeshita, Takuo
149-404, Kishiki-cho 3-chome
Omiya-shi Saitama-ken(JP)
Inventor: Hagino, Sadaaki
7-203, 33-8, Harayama 2-chome
Urawa-shi Saitama-ken(JP)

(74) Representative: Haug, Dietmar et al
Patentanwälte Andrae, Flach, Haug, Kneissl
Steinstrasse 44
D-8000 München 80(DE)

(54) Process for fabricating superconducting ceramics materials.

(57) A process for fabricating worked superconducting ceramics material composed essentially of a yttrium-including rare earth element, an alkaline earth metal, copper and balance oxygen and unavoidable impurities, and optionally containing a metal originating from an oxygen supply agent, comprising:
(a) providing starting powder composed of:
(i) a member selected from the group consisting of:
(1) a mixt powder composed of powders of component oxides:
(1-1) a yttrium-including rare earth element oxide,
(1-2) an alkaline earth metal oxide, and
(1-3) copper oxide,
and having a composition substantially the same as that of a contemplated superconducting ceramics,
(2) a mixt powder composed of powders of:
(2-1) a partial compound between any two of the component oxides constituting a contemplated superconductive ceramics seselected from (1-1), (1-2) and (1-3), and
(2-2) the rest of the component oxides selected from (1-1), (1-2) and (1-3),
and having a composition substantially the same as that of a contemplated superconducting ceramics,
(3) powder of a superconducting ceramics composed essentially of a yttrium-including rare earth element, an alkaline earth metal, copper and balance oxygen and unavoidable impurities,
(4) a mixt powder composed of at least two members selected from the mixt powders (1), (2) and (3); and
(ii) optionally an oxygen-supply agent;

(b) placing the starting powder in a metal casing, and sealing the metal casing;
(c) optionally heat-treating the starting powder in the metal casing when the starting powder is the mixt powder (i)-(1), (ii)-(2) or (iii)-(4) at a temperature sufficient for calcining the starting powder;

(d) working the metal casing containing the starting powder optionally heat-treated according to the step (c) above into an article having a predetermined form; and

(e) optionally heat-treating the article at a temperature of from 300 °C to 950 °C.

## PROCESS FOR FABRICATING SUPERCONDUCTING CERAMICS MATERIALS

### BACKGROUND OF THE INVENTION

The present invention relates to a process for fabricating superconducting ceramics materials comprising a yttrium-including rare earth element, an alkaline earth metal and copper oxide (hereinafter referred to as "R-A-Cu-O based ceramics") which has a high theoretical oxygen content ratio and thus has a high critical temperature.

Conventional processes for fabricating worked materials such as wire rods, plates, strings, coils, and ribbons made of an R-A-Cu-O based superconducting ceramics include a process in which starting powders, i.e., an $R_2O_3$ powder, an alkaline earth metal carbonate powder, and a CuO powder, each having an average grain size of not greater than 10 $\mu$m (micrometers), are provided and compounded in a predetermined compounding ratio followed by mixing and compacting them to obtain a compacted body, which is then calcined, e.g., in an atmosphere of dry air, at a temperature of from 850 °C to 950 °C to form a superconducting ceramics having a composition of $YBa_2Cu_3O_7$, for example, the ceramics is then ground to obtain powder of an average grain size of not greater than 10 $\mu$m and filled in a pipe of silver (Ag) or copper (Cu), and the pipe filled with the ceramics powder is molded into a worked material of a predetermined shape by cold processing or working such as swaging, rolling with grooved rolls, and processing with a die.

With the above-described conventional processes, it is difficult upon calcination to fabricate superconducting ceramics with an oxygen content as high as up to 100% of theoretical content, and the resulting suerconducting ceramics tends to suffer shortage of oxygen. For example, when fabrication of $YBa_2Cu_3O_7$ is contemplated, product has a composition of $YBa_2Cu_3O_{7-d}$ where $\underline{d}$ indicates degree of deficiency of oxygen. Under the circumstances, high critical temperature of superconducting ceramics worked materials cannot be secured with the conventional processes.

### SUMMARY OF THE INVENTION

An object of the present invention is to obviate defects of the conventional processes and provide a process for fabricating worked superconducting ceramics materials in which deficiency of oxygen can be supplemented with ease.

Another object of the present invention is to provide a process for fabricating worked superconducting ceramics materials having a high critical temperature.

As a result of extensive investigation, it has now been found that the above objects can be attained by controlling the oxygen content of superconducting ceramics material during fabrication thereof.

Therefore, the present invention provides a process for fabricating worked superconducting ceramics material composed essentially of a yttrium-including rare earth element, an alkaline earth metal, copper and balance oxygen and unavoidable impurities, and optionally containing a metal originating from an oxygen supply agent, comprising:

(a) providing starting powder composed of:
(i) a member selected from the group consisting of:
(1) a mixt powder composed of powders of component oxides:
(1-1) a yttrium-including rare earth element oxide,
(1-2) an alkaline earth metal oxide, and
(1-3) copper oxide,
and having a composition substantially the same as that of a contemplated superconducting ceramics,
(2) a mixt powder composed of powders of:
(2-1) a partial compound between any two of the component oxides constituting a contemplated superconductive ceramics secelected from (1-1), (1-2) and (1-3), and
(2-2) the rest of the component oxides selected from (1-1), (1-2) and (1-3),
and having a composition substantially the same as that of a contemplated superconducting ceramics,

(3) powder of a superconducting ceramics composed essentially of a yttrium-including rare earth element, an alkaline earth metal, copper and balance oxygen and unavoidable impurities,

(4) a mixt powder composed of at least two members selected from the mixt powders (1), (2) and (3); and

(ii) optionally an oxygen-supply agent;

(b) placing the starting powder in a metal casing, and sealing the metal casing;

(c) optionally heat-treating the starting powder in the metal casing when the starting powder is the mixt powder (i)-(1), (ii)-(2) or (iii)-(4) at a temperature sufficient for calcining the starting powder;

(d) working the metal casing containing the starting powder optionally heat-treated according to the step (c) above into an article having a predetermined form; and

(e) optionally heat-treating the article.

## DETAILED DESCRIPTION OF THE INVENTION

Hereinafter, description will at first be made on a first typical embodiment of the present invention, in which the oxygen content of superconducting ceramics material is controlled by fabricating worked superconducting ceramics material starting from a mixture of powder of a yttrium-including rare earth element oxide ($R_2O_3$), powder of an alkaline earth metal oxide (AO) and powder of copper oxide (CuO). The composition of these single component oxides are blended so that the resulting mixture has a composition substantially the same as that of a final superconducting ceramics article.

Examples of the yttrium-including rare earth element oxide which can be used include oxides of yttrium-including rare earth element such as $Y_2O_3$, $Er_2O_3$, $Dy_2O_3$, $Yb_2O_3$, $Gd_2O_3$, $Tm_2O_3$, $Nd_2O_3$, $Lu_2O_3$, and $Sm_2O_3$. Of the oxides, generally yttrium oxide is preferred. The yttrium-including rare earth elements can be used singly or in combination with each other.

Examples of the alkaline earth metal oxide which can be used in the present invention include oxides of barium, strontium and calcium, i.e., BaO, SrO and CaO. Barium oxide is preferred. The alkaline earth metal oxides can be used singly or in combination with each other.

The single component oxide powders, i.e., powder of a rare earth element oxide, powder of an alkaline earth metal oxide and powder of copper oxide, each are commercially available.

They can be used as they are or after being ground in order to adjust the mean grain size thereof to a desired size. Usually, single component oxide powders to be used have a mean grain size of not greater than 10 $\mu$m. Generally, smaller mean grain size, e.g., not greater than 5 $\mu$m, is preferred.

The single component oxide powders are well mixed with each other in a predetermined ratio appropriate for fabricating a contemplated superconducting ceramics material and the resulting mixt powder composition as a starting material is filled and sealed in a metal casing or sheath. Preferably, metal sheath which can permeate oxygen is used. Suitable examples of the metal of the metal sheath which can be used include copper, aluminum, and silver. Silver based alloys which may contain one or more other elements such as platinum may be used as far as they do not react with ceramics and they give a good influence on the strength of articles to be fabricated such as wire rod.

The shape of the casing is not limited and can be of any desired form depending on the shape of articles to be contemplated as far as it is suited for holding and sealing therein starting powder.

After filling the mixt powder composition in the metal casing, the casing is sealed in the air or in vacuo. The metal casing containing the starting single component oxide powders is then subjected to calcination.

The mixt powder composition can be calcined at a predetermined temperature, preferably ranging from 850 °C to 950 °C, more preferably from 900 °C to 940 °C, in the air for a period sufficient to convert the mixt powder composition into a superconductive ceramics

After the calcination, the resulting superconducting ceramics is then cold- or hot-worked, e.g., by swaging, processing with grooved rolls, processing with a die, or a like to produce articles having a desired shape, e.g., wire rods, plates, ribbons, strings, coils and the like. Also, the superconducting ceramics article surrounded by the metal casing can be processed so that at least one portion of the ceramics has an open surface; in other words, a part of or the whole metal sheath can be removed from the superconducting ceramics material as by grinding or other conventional means. During the above-described processing, annealing may be performed, if desired.

When superconducting ceramics wire rods and similar articles are to be fabricated, it is practically useful to process the wire rods such that the reduction of area of the wire rod is not less than 60% of the original one in order to increase critical current and critical temperature of the superconducting ceramics article.

Then, the worked materials can be heat-treated generally at a temperature of 300 °C to 950 °C, preferably from 850 °C to 950 °C, and more preferably from 900 °C to 940 °C in order to relieve or relax stress generated during processing, and/or the heat-treatment serves to increase the oxygen content of the superconducting ceramics material.

It is advantageous to add powder of an oxygen-supply agent composed of a metal oxide to the starting powder prior to filling the starting powder in the metal casing in order to supplement oxygen, which tends to be deficient in superconducting ceramics material during calcination, thus enabling further controlling the oxygen content in the resulting superconducting ceramics.

Examples of the metal oxide which can be used for this purpose include $Ag_2O$, $MnO_2$, $MoO_3$, $WO_3$, $V_2O_5$ and $Ti_3O_5$. The amount of the oxygen-supply agent to be added is preferably 1 to 5 % by weight based on the total powder composition. When the metal casing having filled therein the starting powder composition containing powder of the metal oxide as an oxygen-supply agent is heated, the metal oxide releases oxygen to compensate the ceramics composition for the deficiency of oxygen to increase the theoretical oxygen content ratio of the ceramics.

Alternative approach for increasing the theoretical oxygen content ratio is to provide an oxide layer on the inner surface of the metal sheath as by oxidizing the inner surface of the sheath by heating it in the air prior to introducing therein the starting powder.

It is sometimes useful to add the oxygen-supply agent in the starting superconducting ceramics powder and at the same time provide an oxide layer on the inner surface of the metal sheath.

In another embodiment of this invention, superconducting ceramics material can be fabricated starting from powder of a superconducting ceramics (R-A-Cu-O) composed essentially of a yttrium-including rare earth element (R), an alkaline earth metal (A), copper (Cu), and balance oxygen (O) and unavoidable impurities.

Suitable examples of the yttrium-including rare earth element which can be used include yttrium (Y), erbium (Er), dysprosium (Dy), ytterbium (Yb), gadolinium (Gd), thulium (Tm), neodymium (Nd), (Lu), and samarium (Sm). Of these, yttrium is preferred. The yttrium-including rare earth elements can be used singly or in combination with each other.

Suitable examples of the alkaline earth metal which can be used in the present invention include barium (Ba), strontium (Sr) and calcium (Ca), with barium being preferred. The alkaline earth metal can be used singly or in combination with each other.

Powder of superconducting ceramics which can be used as a starting powder in the process of the present invention can be prepared, e.g., by calcining a mixture of single component oxides with a composition substantially the same as that of a contemplated ceramics material or article in an oven at a temperature suitable for preparing ceramics, e.g., 850 to 950 °C, and grinding the resulting superconducting ceramics material to have a desired mean grain size, e.g., not greater than 10 $\mu$m. Generally, smaller mean grain size, e.g., not greater than 5 $\mu$m, is preferred. Of course, it is possible to use superconducting ceramics material otherwise prepared as far as it has a composition of R-A-Cu-O, e.g., $YBa_2Cu_3O_7$, to be fabricated after grinding, if desired. Examples of known ceramics include those described, e.g., in Tomoji Kawai and Masaki Kanai, Japanese Journal of Applied Physics, vol. 26, No. 5, May, 1987, pp.L736-L737; and Masanobu Kobayashi et al., ibid., vol. 26, No. 5, May, 1987, pp.L754-L756.

The starting superconducting ceramics powder is filled and sealed in a metal casing or sheath in the air or in vacuo. The same metal casing as explained in connection with the embodiment in which a mixture of single component oxide powders are used can be used as a starting material.

The sealed metal casing containing therein the starting superconducting ceramics powder is then worked in the same manner as in the case of fabricating worked superconducting ceramics materials starting from the single component oxide powders described above

When superconducting ceramics wire rods and similar articles are to be fabricated it is practically useful to work the wire rods such that the reduction of area of the wire rod is not less tha 60% of the original one in order to increase critical current and critical temperature of the superconducting ceramics article.

Then, the worked materials can be heat-treated generally at a temperature of 300 °C to 950 °C, preferably from 850 °C to 950 °C, and more preferably from 900 °C to 940 °C in order to relieve or relax stress generated during processing, and/or the heat-treatment serves to increase the oxygen content of the superconducting ceramics material.

Further, it is advantageous to add an oxygen-supply agent to the starting superconducting ceramics powder and/or to provide an oxide layer on the inner surface of the metal casing in the same manner as in the case of fabricating the superconducting ceramics article starting from single component oxide powders. The same kind and amount of the oxygen-supply agent as described above can be used.

Further, according to a variation of the above-described embodiments, powder of partial compounds between any two of the component oxides for fabricating superconducting ceramics articles, i.e., a compound between the yttrium-including rare earth element and the alkaline earth metal oxide, a compound between the alkaline earth metal and copper oxide, and a compound between copper oxide and the yttrium-including rare earth element, can be used together with powder of the remainder of the component oxides, ie., copper oxide, the yttrium-including rare earth element, and the alkaline earth metal, respectively, instead of using a mixture of powders of single component oxides alone as a starting powder. For example, Y-Ba-CuO based superconducting ceramics articles can be fabricated using $Y_2O_3 \bullet BaO$ and $CuO$ in a composition substantially the same as that of the final ceramics. Other combinations such as $CuO \bullet BaO$, and $Y_2O_3 \bullet CuO$, together with $Y_2O_3$, and $BaO$, respectively, can also be used. Similarly, partial compounds can be used for ceramics compositions containing other yttrium-including rare earth elements.

The partial compounds between any two of the single component oxides for fabricating superconducting ceramics material can be commercially available or can be prepared in conventional manner, e.g. by calcining a mixture of powders of any two of the single component oxides described above in an oven at temperatures suitable for preparation of ceramics.

The ratio of powder of the partial compound to the remainder single component oxide which can be added is not critical as far as the resulting mixture has a composition substantially the same as that of a superconducting ceramics article to be obtained finally.

According to another variation, the mixt powder of the single component oxides, and/or the mixt powder of the partial compound and the remainder of the single component oxides described above, can be added to powder of the superconducting ceramics powder. In this case, the mixing ratio therebetween is not critical.

In the above-described variations, the same operations including calcination and working as performed in the case of fabrication of worked superconducting ceramics materials starting from a mixture of powders of single component oxides can be carried out under substantially the same conditions as above, and detailed explanation is omitted herein.

In the above-described variations, it is also advantageous to add an oxygen-supply agent to the starting powder. As the oxygen-supply agent can be used the same metal oxides described above with respect to the preceding embodiments of this invention in the same amounts as used therein. In addition, an oxide layer may be provided in the inner surface of the metal sheath similarly to the above-described embodiments, if desired.

According to the variations of the proces of the present invention, worked superconducting ceramics materials having a high theoretical oxygen content ratio and a high critical temperature can be obtained as in the preceding embodiments.

## EXAMPLES

The present invention will be explained in greater detail with reference to the following examples, which should in no way be construed as limiting the present invention.

In tables, "rem." stands for "remainder".

## Example 1

As starting powder, $R_2O_3$ powder, $AO$ powder and $CuO$ powder each having a predetermined mean grain size of from 0.5 to 10 $\mu m$ were blended at a blend ratio shown in Table 1a. After mixing, the resulting mixture was filled into a cylindrical metal casing made of Ag having a size of 10 mm in inner diameter. 1 mm thick and 100 mm long at a filling ratio of 50% and the casing was sealed in vacuo. Then. the thus-filled casing was was calcined by holding it in the air at a predetermined temperature in the range of 850 to 950 °C to convert the powders in the metal casing into supercoducting ceramics. which was then cold-worked by subjecting it to swaging and grooved roll-processing, each in a plurality of times, followed by drawing the product into wire rod at an area reduction shown in Table 1b below. Then. the wire rod was annealed for stress-relief at a predetermined temperature in the range of from 300 to 500 °C for 10 to 20 minutes, thus producing R-A-Cu-O based superconducting ceramics wire rods.

For comparison, R-A-Cu-O based superconducting ceramics powder having a mean grain size and composition shown in Table 1a was filled in the same cylindrical Ag casing as described above at a filling ratio of 50%. After sealing it in vacuo, the casing was immediately cold-processed under the same conditions as above to obtain wire rod, which was then heat-treated in the same manner as above to effect annealing for stress-relief, thus producing comparative wire rods.

The theoretical oxygen content ratio and critical temperature (Tc) of the supeconducting ceramics wire rods thus obtained were determined and the results obtained are shown in Table 1c.

From the results shown in Table 1c below, it can be seen that the superconducting ceramics wire rods fabricated according to the process of the present invention had a theoretical oxygen content ratio much higher than that of the comparative wire rods. These results correspond to high critical temperature.

Table 1a

| Run No. | Starting Powder | | |
|---|---|---|---|
| | Composition (wt.%) | | |
| | $R_2O_3$ | AO | CuO |
| 1-1 | $Y_2O_3$: 17.15 | BaO: 46.59 | rem. |
| 1-2 | $Er_2O_3$: 25.97 | BaO: 41.63 | rem. |
| 1-3 | $Dy_2O_3$: 25.50 | BaO: 41.89 | rem. |
| 1-4 | $Yb_2O_3$: 26.54 | BaO: 41.32 | rem. |
| 1-5 | $Gd_2O_3$: 24.95 | BaO: 42.21 | rem. |
| 1-6 | $Tm_2O_3$: 26.13 | BaO: 41.55 | rem. |
| 1-7 | $Nd_2O_3$: 23.58 | BaO: 42.98 | rem. |
| 1-8 | $Lu_2O_3$: 26.73 | BaO: 41.21 | rem. |
| 1-9 | $Sm_2O_3$: 24.23 | BaO: 42.61 | rem. |
| 1-10 | $Y_2O_3$: 17.41 | BaO: 42.58 SrO: 3.20 | rem. |
| 1-11 | $Lu_2O_3$: 27.09 | BaO: 39.66 CaO: 0.76 | rem. |

Table 1b

| Run No. | Starting Powder | | | | Mean Grain Size ($\mu$m) |
|---|---|---|---|---|---|
| | Composition (wt.%) | | | | |
| | R | A | Cu | O | |
| 1-12 | Y: 13.3 | Ba: 41.2 | 28.6 | rem. | 0.5 |
| 1-13 | Er: 22.5 | Ba: 36.9 | 25.6 | rem. | 1.2 |
| 1-14 | Dy: 22.0 | Ba: 37.1 | 25.8 | rem. | 3.2 |
| 1-15 | Yb: 23.1 | Ba: 36.6 | 25.4 | rem. | 1.5 |
| 1-16 | Gd: 21.4 | Ba: 37.4 | 26.0 | rem. | 1.6 |
| 1-17 | Tm: 22.6 | Ba: 36.8 | 25.5 | rem. | 0.8 |
| 1-18 | Nd: 20.0 | Ba: 38.1 | 26.5 | rem. | 0.9 |
| 1-19 | Lu: 23.3 | Ba: 36.5 | 25.3 | rem. | 1.8 |
| 1-20 | Sm: 20.7 | Ba: 37.7 | 26.2 | rem. | 1.9 |
| 1-21 | Y: 13.5 | Ba: 37.7 Sr: 2.7 | 29.0 | rem. | 0.4 |
| 1-22 | Lu: 23.5 | Ba: 35.1 Ca: 0.5 | 25.7 | rem. | 3.5 |

Table 1c

| Run No. | Area Reduction | Diameter of Wire Rod | Theotical Oxygen Content Ratio | Tc |
|---|---|---|---|---|
| | (%) | (mm) | (%) | (°C) |
| 1-1 | 98 | 1.2 | 99.2 | 88 |
| 1-2 | 98 | 1.2 | 98.9 | 85 |
| 1-3 | 98 | 1.2 | 99.0 | 87 |
| 1-4 | 90 | 2.7 | 99.0 | 87 |
| 1-5 | 95 | 1.9 | 99.1 | 88 |
| 1-6 | 98 | 1.2 | 99.2 | 88 |
| 1-7 | 90 | 2.7 | 99.2 | 88 |
| 1-8 | 95 | 1.9 | 98.8 | 85 |
| 1-9 | 98 | 1.2 | 99.2 | 88 |
| 1-10 | 98 | 1.2 | 99.1 | 88 |
| 1-11 | 98 | 1.2 | 99.0 | 88 |
| 1-12 | Same as 1-1 above | | 98.0 | 80 |
| 1-13 | Same as 1-2 above | | 98.0 | 78 |
| 1-14 | Same as 1-3 above | | 97.6 | 68 |
| 1-15 | Same as 1-4 above | | 98.0 | 78 |
| 1-16 | Same as 1-5 above | | 97.6 | 69 |
| 1-17 | Same as 1-6 above | | 97.5 | 66 |
| 1-18 | Same as 1-7 above | | 97.4 | 65 |
| 1-19 | Same as 1-8 above | | 98.0 | 80 |
| 1-20 | Same as 1-9 above | | 97.8 | 77 |
| 1-21 | Same as 1-10 above | | 97.6 | 76 |
| 1-22 | Same as 1-11 above | | 97.8 | 75 |

Example 2

As starting powder, $R_2O_3$ powder, AO powder and CuO powder having a predetermined mean grain size of from 0.5 to 10 μm and various metal oxide powders were blended at a blend ratio shown in Table 2a. After mixing, the resulting mixture was filled into a cylindrical casing made of Cu having a size of 10 mm in inner diameter, 1 mm thick and 100 mm long at a filling ratio of 50% and the casing was sealed in vacuo. The metal casing was calcined by holding it in the air at a predetermined temperature in the range of 850 to 950 °C to convert the powders in the metal casing into supercoducting ceramics. Then, the thus-synthesized ceramics cold-worked by subjecting it to swaging and grooved roll-processing, each in a plurality of times, followed by drawing the product into wire rod at an area reduction shown in Table 2c below. Then, the wire rod was heat-treated at a predetermined temperature in the range of from 300 to 500 °C for 10 to 20 minutes to effect annealing for stress-relief. thus producing R-A-Cu-O based superconducting ceramics wire rods.

For comparison, R-A-Cu-O based superconducting ceramics powder having a mean grain size and composition shown in Table 2b was filled in the same cylindrical Cu casing as described above at a filling ratio of 50%. After sealing it in vacuo, the casing was immediately cold processed under the same conditions as above to obtain wire rod, which was then heat-treated in the same manner as above to effect annealing for stress-relief, thus producing comparative wire rods.

The theoretical oxygen content ratio and critical temperature (Tc) of the superconducting ceramics wire

8

rods thus obtained were determined and the results obtained are shown in Tables 2c.

From the results shown in Tables 2c below, it can be seen that the superconducting ceramics wire rods fabricated according to the process of the present invention had a theoretical oxygen content ratio much higher than that of the comparative wire rods. These results correspond to high critical temperature.

Table 2a

| Run No. | Starting Powder | | | Oxygen Supply Agent (wt.%) |
|---|---|---|---|---|
| | Composition (wt.%) | | | |
| | $R_2O_3$ | AO | CuO | |
| 2-1 | $Y_2O_3$: 16.81 | BaO: 45.66 | rem. | $Ag_2O$ 2 |
| 2-2 | $Er_2O_3$: 25.71 | BaO: 41.21 | rem. | $WO_3$ 1 |
| 2-3 | $Dy_2O_3$: 25.19 | BaO: 41.39 | rem. | $V_2O_3$ 1.2 |
| 2-4 | $Yb_2O_3$: 26.14 | BaO: 40.70 | rem. | $Ti_3O_5$ 1.5 |
| 2-5 | $Cd_2O_3$: 24.33 | BaO: 41.15 | rem. | $Ag_2O$ 2 $MnO_2$ 0.5 |
| 2-6 | $Tm_2O_3$: 25.82 | BaO: 41.05 | rem. | $MoO_3$ 1.2 |
| 2-7 | $Nd_2O_3$: 23.34 | BaO: 42.55 | rem. | $Ti_3O_5$ 1 |
| 2-8 | $Lu_2O_3$: 26.20 | BaO: 40.39 | rem. | $Ag_2O$ 2 $V_2O_3$ 0.5 $MoO_3$ 0.5 |
| 2-9 | $Sm_2O_3$: 23.50 | BaO: 41.33 | rem. | $MnO_2$ 3 |
| 2-10 | $Y_2O_3$: 16.54 | BaO: 40.45 SrO: 3.04 | rem. | $Ag_2O$ 5 |
| 2-11 | $Lu_2O_3$: 26.01 | BaO: 38.07 CaO: 0.73 | rem. | $WO_3$ 2 $Ti_3O_5$ 2 |

Table 2b

| Run No. | Starting Powder | | | | Mean Grain Size (μm) |
|---|---|---|---|---|---|
| | Composition (wt.%) | | | | |
| | R | A | Cu | O | |
| 2-12 | Y: 13.3 | Ba: 41.2 | 28.6 | rem. | 1.0 |
| 2-13 | Er: 22.5 | Ba: 36.9 | 25.6 | rem. | 3.3 |
| 2-14 | Dy: 22.0 | Ba: 37.1 | 25.8 | rem. | 3.1 |
| 2-15 | Yb: 23.1 | Ba: 36.6 | 25.4 | rem. | 3.7 |
| 2-16 | Gd: 21.4 | Ba: 37.4 | 26.0 | rem. | 3.0 |
| 2-17 | Tm: 22.6 | Ba: 36.8 | 25.5 | rem. | 3.4 |
| 2-18 | Nd: 20.0 | Ba: 38.1 | 26.5 | rem. | 3.3 |
| 2-19 | Lu: 23.3 | Ba: 36.5 | 25.3 | rem. | 3.2 |
| 2-20 | Sm: 20.7 | Ba: 37.7 | 26.2 | rem. | 3.5 |
| 2-21 | Y: 13.5 | Ba: 37.7 Sr: 2.7 | 29.0 | rem. | 4.0 |
| 2-22 | Lu: 23.5 | Ba: 35.1 Ca: 0.5 | 25.7 | rem. | 3.3 |

Table 2c

| Run No. | Area Reduction | Diameter of Wire Rod | Theotical Oxygen Content Ratio | Tc |
|---|---|---|---|---|
| | (%) | (mm) | (%) | (°C) |
| 2-1 | 98 | 1.2 | 99.9 | 98 |
| 2-2 | 98 | 1.2 | 99.8 | 97 |
| 2-3 | 90 | 2.7 | 99.7 | 97 |
| 2-4 | 95 | 1.9 | 99.7 | 96 |
| 2-5 | 98 | 1.2 | 99.8 | 97 |
| 2-6 | 90 | 2.7 | 99.6 | 96 |
| 2-7 | 95 | 1.9 | 99.5 | 95 |
| 2-8 | 98 | 1.2 | 99.8 | 96 |
| 2-9 | 98 | 1.2 | 99.5 | 95 |
| 2-10 | 98 | 1.2 | 99.9 | 100 |
| 2-11 | 95 | 1.9 | 99.5 | 94 |
| 2-12 | Same as 2-1 above | | 98.0 | 81 |
| 2-13 | Same as 2-2 above | | 98.0 | 79 |
| 2-14 | Same as 2-3 above | | 98.1 | 77 |
| 2-15 | Same as 2-4 above | | 98.5 | 80 |
| 2-16 | Same as 2-5 above | | 97.9 | 76 |
| 2-17 | Same as 2-6 above | | 98.0 | 80 |
| 2-18 | Same as 2-7 above | | 97.6 | 74 |
| 2-19 | Same as 2-8 above | | 98.6 | 82 |
| 2-20 | Same as 2-9 above | | 98.5 | 82 |
| 2-21 | Same as 2-10 above | | 98.4 | 83 |
| 2-22 | Same as 2-11 above | | 97.6 | 77 |

## Example 3

R-A-Cu-O bases superconducting ceramics powder having mean grain sizes and compositions as shown in Table 3a below and a metal oxide powder as an oxygen-supply agent as shown in Table 3a below were blended at a blend ratio shown in Table 3a. After mixing, the resulting starting powder compositions were each filled into a cylindrical casing made of Cu having a size of 10 mm in inner diameter, 1 mm thick and 100 mm long at a filling ratio of 50%. After sealing it in vacuo, the casing containing therein the starting powder composition was cold-worked by subjecting it to swaging and grooved roll-working, each in a plurality of times, followed by drawing the product into wire rod at an area reduction shown in Table 3c below to obtain wire rods. The wire rods were heat-treated for oxygen supply at a predetermined temperature in the range of from 300 $^\circ$C to 850 $^\circ$C for 60 minutes to fabricate R-A-Cu-O type superconducting ceramics wire rods.

For comparison, R-A-Cu-O based superconducting ceramics powder having a mean grain size and composition shown in Table 3a was filled in the same cylindrical Cu casing as described above at a filling ratio of 50%. After sealing it in vacuo, the casing was immediately cold-worked under the same conditions as above to obtain wire rod, which was then heat-treated at a predetermined temperature in the range of from 300 to 500 $^\circ$C for 15 minutes to anneal it for stress-relief, thus producing comparative wire rods.

The theoretical oxygen content ratio and critical temperature (Tc) of the superconducting ceramics wire rods thus obtained were determined and the results obtained are shown in Table 3c.

From the results shown in Table 3c below, it can be seen that the superconducting ceramics wire rods fabricated according to the process of the present invention had a theoretical oxygen content ratio much higher than that of the comparative wire rods. These results correspond to high critical temperature.

Table 3a

| Run No. | Composition of Starting Powders | | | | | |
|---|---|---|---|---|---|---|
| | Composition (wt.%) | | | | Mean Grain Size ($\mu$m) | SCC (wt.%) |
| | R | A | Cu | O | | |
| 3-1 | Y: 13.3 | Ba: 41.2 | 28.6 | rem. | 0.5 | 98 |
| 3-2 | Er: 22.5 | Ba: 36.9 | 25.6 | rem. | 0.7 | 97 |
| 3-3 | Dy: 22.0 | Ba: 37.1 | 25.8 | rem. | 1.0 | 98.8 |
| 3-4 | Yb: 23.1 | Ba: 36.6 | 25.4 | rem. | 1.2 | 97.5 |
| 3-5 | Gd: 21.4 | Ba: 37.4 | 26.0 | rem. | 2.0 | 99 |
| 3-6 | Tm: 22.6 | Ba: 36.8 | 25.5 | rem. | 0.6 | 98.8 |
| 3-7 | Nd: 20.0 | Ba: 38.1 | 26.5 | rem. | 2.5 | 97 |
| 3-8 | Lu: 23.3 | Ba: 36.5 | 25.3 | rem. | 3.0 | 98.8 |
| 3-9 | Sm: 20.7 | Ba: 37.7 | 26.2 | rem. | 3.1 | 99 |
| 3-10 | Y: 13.5 | Ba: 37.7 Sr: 2.7 | 29.0 | rem. | 0.8 | 98.5 |
| 3-11 | Lu: 23.5 | Ba: 35.1 Ca: 0.5 | 25.7 | rem. | 2.0 | 99 |
| 3-12 | Same as 3-1 above | | | | | 100 |
| 3-13 | Same as 3-2 above | | | | | 100 |
| 3-14 | Same as 3-3 above | | | | | 100 |
| 3-15 | Same as 3-4 above | | | | | 100 |
| 3-16 | Same as 3-5 above | | | | | 100 |
| 3-17 | Same as 3-6 above | | | | | 100 |
| 3-18 | Same as 3-7 above | | | | | 100 |
| 3-19 | Same as 3-8 above | | | | | 100 |
| 3-20 | Same as 3-9 above | | | | | 100 |
| 3-21 | Same as 3-10 above | | | | | 100 |
| 3-22 | Same as 3-11 above | | | | | 100 |

Table 3b

| Run No. | Oxygen Supply Agent | | |
|---------|-------------|--------------------|---------|
| | Composition | Mean Grain Size | Content |
| | | ($\mu$m) | (wt.%) |
| 3-1 | $Ag_2O$ | 5 | 2 |
| 3-2 | $MnO_2$ | 6 | 3 |
| 3-3 | $MoO_3$ | 4 | 1.2 |
| 3-4 | $Ag_2O$ | 5 | 2 |
| | $V_2O_3$ | 8 | 0.5 |
| 3-5 | $WO_3$ | 6 | 1 |
| 3-6 | $V_2O_3$ | 8 | 1.2 |
| 3-7 | $Ag_2O$ | 5 | 3 |
| 3-8 | $V_2O_3$ | 8 | 0.7 |
| | $Ti_3O_5$ | 4 | 0.5 |
| 3-9 | $Ti_3O_5$ | 4 | 1 |
| 3-10 | $MnO_2$ | 6 | 0.5 |
| | $WO_3$ | 7 | 1 |
| 3-11 | $Ti_3O_5$ | 1 | 1 |
| 3-12 | - | - | - |
| 3-13 | - | - | - |
| 3-14 | - | - | - |
| 3-15 | - | - | - |
| 3-16 | - | - | - |
| 3-17 | - | - | - |
| 3-18 | - | - | - |
| 3-19 | - | - | - |
| 3-20 | - | - | - |
| 3-21 | - | - | - |
| 3-22 | - | - | - |

Table 3c

| Run No. | Area Reduction | Diameter of Wire Rod | Theotical Oxygen Content Ratio | Tc |
|---|---|---|---|---|
| | (%) | (mm) | (%) | (°C) |
| 3-1 | 98 | 1.2 | 99.6 | 96 |
| 3-2 | 95 | 1.9 | 98.5 | 95 |
| 3-3 | 98 | 1.2 | 99.4 | 93 |
| 3-4 | 90 | 2.7 | 99.2 | 91 |
| 3-5 | 95 | 1.9 | 99.3 | 92 |
| 3-6 | 98 | 1.2 | 99.5 | 95 |
| 3-7 | 95 | 1.9 | 99.4 | 93 |
| 3-8 | 90 | 2.7 | 99.1 | 90 |
| 3-9 | 98 | 1.2 | 99.2 | 92 |
| 3-10 | 98 | 1.2 | 99.7 | 96 |
| 3-11 | 95 | 1.9 | 99.5 | 92 |
| 3-12 | Same as 3-1 above | | 98.1 | 82 |
| 3-13 | Same as 3-2 above | | 98.2 | 80 |
| 3-14 | Same as 3-3 above | | 98.4 | 80 |
| 3-15 | Same as 3-4 above | | 98.1 | 79 |
| 3-16 | Same as 3-5 above | | 98.2 | 78 |
| 3-17 | Same as 3-6 above | | 98.3 | 79 |
| 3-18 | Same as 3-7 above | | 98.7 | 84 |
| 3-19 | Same as 3-8 above | | 98.5 | 82 |
| 3-20 | Same as 3-9 above | | 98.6 | 87 |
| 3-21 | Same as 3-10 above | | 98.2 | 85 |
| 3-22 | Same as 3-11 above | | 98.0 | 80 |

## Example 4

Various starting powders composed of R-A-Cu-O based superconducting ceramics powders having mean grain sizes and compositions as shown in Table 4a below were filled at a filling ratio of 50% into a cylindrical casing made of Cu having a size of 10 mm in inner diameter, 1 mm thick and 100 mm long and having formed on its inner surface an oxide layer of a thickness of 50 um by holding it in the air at a temperature of 830°C for 0.5 hour, and the thus-filled casing was cold-worked by subjecting it to swaging and grooved roll-working, each in a plurality of times, followed by drawing the product into wire rod at an area reduction shown in Table 4b below to obtain wire rods. The wire rods were heat-treated at a predetermined temperature in the range of from 300°C to 850°C for 60 minutes to effect oxygen supply from the inner oxide layer, thus fabricating R-A-Cu-O type superconducting ceramics wire rods.

For comparison, the same procedures as above were repeated except that Cu casing without having formed an oxide layer on its inner surface was used and that annealing for stress-relief was performed at a predetermined temperature in the range of 300 to 500°C for a predetermined period of time in the range of 10 to 20 minutes instead of the heat-treatment for oxygen supply to obtain comparative wire rods.

The theoretical oxygen content ratio and critical temperature (Tc) of the superconducting ceramics wire rods thus obtained were determined and the results obtained are shown in Table 4c.

From the results shown in Table 4c below, it can be seen that the superconducting ceramics wire rods fabricated according to the process of the present invention had a theoretical oxygen content ratio much higher than that of the comparative wire rods. These results correspond to high critical temperature.

Table 4a

| Run No. | Starting Powder | | | | Mean Grain Size (μm) |
|---|---|---|---|---|---|
| | Composition (wt.%) | | | | |
| | R | A | Cu | O | |
| 4-1 | Y: 13.3 | Ba: 41.2 | 28.6 | rem. | 1.0 |
| 4-2 | Er: 22.5 | Ba: 36.9 | 25.6 | rem. | 3.3 |
| 4-3 | Dy: 22.0 | Ba: 37.1 | 25.8 | rem. | 3.1 |
| 4-4 | Yb: 23.1 | Ba: 36.6 | 25.4 | rem. | 3.7 |
| 4-5 | Gd: 21.4 | Ba: 37.4 | 26.0 | rem. | 3.0 |
| 4-6 | Tm: 22.6 | Ba: 36.8 | 25.5 | rem. | 3.4 |
| 4-7 | Nd: 20.20 | Ba: 38.1 | 26.5 | rem. | 3.3 |
| 4-8 | Lu: 23.3 | Ba: 36.5 | 25.3 | rem. | 3.2 |
| 4-9 | Sm: 20.7 | Ba: 37.7 | 26.2 | rem. | 3.5 |
| 4-10 | Y: 13.5 | Ba: 37.7 Sr: 2.7 | 29.0 | rem. | 4.0 |
| 4-11 | Lu: 23.5 | Ba: 35.1 Ca: 0.5 | 25.7 | rem. | 3.3 |
| 4-12 | Same as 4-1 above | | | | |
| 4-13 | Same as 4-2 above | | | | |
| 4-14 | Same as 4-3 above | | | | |
| 4-15 | Same as 4-4 above | | | | |
| 4-16 | Same as 4-5 above | | | | |
| 4-17 | Same as 4-6 above | | | | |
| 4-18 | Same as 4-7 above | | | | |
| 4-19 | Same as 4-8 above | | | | |
| 4-20 | Same as 4-9 above | | | | |
| 4-21 | Same as 4-10 above | | | | |
| 4-22 | Same as 4-11 above | | | | |

EP 0 305 949 A1

Table 4b

| Run No. | Area Reduction | Diameter of Wire Rod | Theotical Oxygen Content Ratio | Tc |
|---|---|---|---|---|
| | (%) | (mm) | (%) | ($^\circ$ C) |
| 4-1 | 98 | 1.2 | 99.2 | 92 |
| 4-2 | 98 | 1.2 | 98.1 | 91 |
| 4-3 | 95 | 1.9 | 99.2 | 90 |
| 4-4 | 90 | 2.7 | 98.9 | 89 |
| 4-5 | 98 | 1.2 | 98.8 | 88 |
| 4-6 | 95 | 1.9 | 99.0 | 90 |
| 4-7 | 90 | 2.7 | 99.0 | 90 |
| 4-8 | 95 | 1.9 | 99.1 | 91 |
| 4-9 | 98 | 1.2 | 98.9 | 89 |
| 4-10 | 95 | 1.9 | 99.4 | 94 |
| 4-11 | 90 | 2.7 | 99.2 | 90 |
| 4-12 | Same as 4-1 above | | 98.0 | 80 |
| 4-13 | Same as 4-2 above | | 97.9 | 78 |
| 4-14 | Same as 4-3 above | | 98.1 | 79 |
| 4-15 | Same as 4-4 above | | 97.6 | 72 |
| 4-16 | Same as 4-5 above | | 97.9 | 74 |
| 4-17 | Same as 4-6 above | | 97.5 | 70 |
| 4-18 | Same as 4-7 above | | 97.6 | 72 |
| 4-19 | Same as 4-8 above | | 98.0 | 79 |
| 4-20 | Same as 4-9 above | | 97.8 | 74 |
| 4-21 | Same as 4-10 above | | 98.2 | 78 |
| 4-22 | Same as 4-11 above | | 97.4 | 70 |

17

Obviously many modifications and variations of the present invention are possible in the light of the above teachings. It is therefore, to be understood that within the scope of the appended claims the invention may be practiced otherwise than as specifically described.

**Claims**

1. A process for fabricating worked superconducting ceramics material composed essentially of a yttrium-including rare earth element, an alkaline earth metal, copper and balance oxygen and unavoidable impurities, and optionally containing a metal originating from an oxygen supply agent, comprising:
    (a) providing starting powder composed of:
(i) a member selected from the group consisting of:
(1) a mixt powder composed of powders of component oxides:
(1-1) a yttrium-including rare earth element oxide,
(1-2) an alkaline earth metal oxide, and
(1-3) copper oxide,
and having a composition substantially the same as that of a contemplated superconducting ceramics,
(2) a mixt powder composed of powders of:
(2-1) a partial compound between any two of the component oxides constituting a contemplated superconductive ceramics secelected from (1-1), (1-2) and (1-3), and
(2-2) the rest of the component oxides selected from (1-1), (1-2) and (1-3),
and having a composition substantially the same as that of a contemplated superconducting ceramics,
(3) powder of a superconducting ceramics composed essentially of a yttrium-including rare earth element, an alkaline earth metal, copper and balance oxygen and unavoidable impurities,
(4) a mixt powder composed of at least two members selected from the mixt powders (1), (2) and (3); and
(ii) optionally an oxygen-supply agent;
    (b) placing the starting powder in a metal casing, and sealing the metal casing;
    (c) optionally heat-treating the starting powder in the metal casing when the starting powder is the mixt powder (i)-(1), (ii)-(2) or (iii)-(4) at a temperature sufficient for calcining the starting powder;
    (d) working the metal casing containing the starting powder optionally heat-treated according to the step (c) above into an article having a predetermined form; and
    (e) optionally heat-treating the article.

2. The process as claimed in Claim 1, wherein said starting powder is composed of the mixt powder (1).

3. The process as claimed in Claim 2, wherein said yttrium-including rare earth element oxide (1-1) is yttrium oxide.

4. The process as claimed in any one of Claims 1 to 3, wherein said alkaline earth metal oxide (1-2) is barium oxide.

5. The process as claimed in Claim 1, wherein said starting powder is composed of the powder (3).

6. The process as claimed in Claim 6, wherein said yttrium-including rare earth element is yttrium.

7. The process as claimed in Claim 5 or 6, wherein said alkaline earth metal is barium.

8. The process as claimed in any one of Claims 1 to 7, wherein said starting powder further comprises the oxygen-supply agent.

9. The process as claimed in Claim 8, wherein said oxygen-supply agent is $Ag_2O$, $MnO_2$, $MoO_3$, $WO_3$, $V_2O_5$ or $Ti_3O_5$.

10. The process as claimed in claim 10, wherein said oxygen-supply agent is $Ag_2O$.

11. The process as claimed in any one of Claims 1 to 10, further comprising providing an oxide layer on the inner surface of said metal casing.

12. The process as claimed in any one of Claim 1 to 11, wherein said heat-treatment (c) is performed at a temperature of from 850 °C to 950 °C.

13. The process as claimed in any one of Claim 1 to 12, wherein said heat treatment (e) is performed at a temperature of from 300 to 950 °C.

14. The process as claimed in any one of Claim 1 to 13, wherein said metal casing is made of a metal selected from the group consisting of copper, silver, and aluminum, and alloys thereof.

15. The process as claimed in Claim 14, wherein said metal casing is made of silver and its alloy.

| **DOCUMENTS CONSIDERED TO BE RELEVANT** | | | EP 88114052.9 |
|---|---|---|---|
| Category | Citation of document with indication, where appropriate, of relevant passages | Relevant to claim | CLASSIFICATION OF THE APPLICATION (Int. Cl.4) |
| X | JAPANESE JOURNAL OF APPLIED PHYSICS, part 2, letters, vol. 26, no. 5, May 1987, Japan<br><br>Y.YAMADA et al. "Critical Current Density of Wire Type Y-Ba-Cu Oxide Superconductor"<br>pages L865-L866<br><br>* Page L865 *<br><br>----- | 1-7,14 | C 04 B 35/00<br><br>H 01 L 39/24<br><br>C 04 B 35/60 |

**TECHNICAL FIELDS SEARCHED (Int. Cl.4)**

C 04 B

H 01 B

H 01 L

The present search report has been drawn up for all claims

| Place of search | Date of completion of the search | Examiner |
|---|---|---|
| VIENNA | 07-12-1988 | BECK |